Europäisches Patentamt

European Patent Office

Office européen des brevets

(11) Publication number: **0 259 162**
**A2**

# EUROPEAN PATENT APPLICATION

(21) Application number: **87307785.3**

(22) Date of filing: **03.09.87**

(51) Int. Cl.4: **G 01 R 1/073**
**H 01 R 11/18**

(30) Priority: **05.09.86 US 904145**

(43) Date of publication of application:
**09.03.88 Bulletin 88/10**

(84) Designated Contracting States: **DE FR GB NL**

(71) Applicant: **TEKTRONIX, INC.**
**Howard Vollum Park 14150 S.W. Karl Braun Drive P.O.**
**Box 500**
**Beaverton Oregon 97077 (US)**

(72) Inventor: **Creedon, Theodore G.**
**5740 S.W. Childs Road**
**Lake Oswego Oregon 97034 (US)**

(74) Representative: **Burke, Steven David et al**
**R.G.C. Jenkins & Co. 26 Caxton Street**
**London SW1H 0RJ (GB)**

(54) **Integrated circuit probe system.**

(57) The interface between an integrated circuit probing element and associated test equipment is provided by flexible ribbon cables that include a plurality of transmission lines. The cables are not an integral part of the probe housing, so their lengths can be selected independently of housing size constraints and can be chosen instead to optimize probe performance. The ribbon cable construction eliminates the many transmission line transitions found in conventional probing systems, thereby increasing probe bandwidth. The ribbon cable can be formed for direct connection to associated test equipment to eliminate all transmission line transitions.

F I G. I

**Description**

INTEGRATED CIRCUIT PROBE SYSTEM

TECHNICAL FIELD

The present invention relates to probes for multilead testing of IC wafers.

BACKGROUND OF THE INVENTION

An important step in the production of integrated circuits is to test each circuit to determine whether it has properly been manufactured. It is generally desirable to conduct such testing as early as possible in the fabrication process. The earliest this can be done is after wafer fabrication is completed, before separation into dice. The next opportunity is to test the dice before they are packaged. In either case, it is necessary to make electrical connection to all of the circuit's external connections (usually bonding pads) in a nondestructive way so that normal packaging and connection is subsequently possible.

It is also desirable to test the circuit both at its normal operating conditions and at the extremes of its performance range. For high speed circuits, such as those having signal bandwidths exceeding one GHz, it is important to be able to evaluate circuit operation at full speed. In the past, this has been difficult or impossible due to bandwidth limitations of conventional wafer probing systems.

One source of bandwidth limitation in conventional wafer probing systems has been the number of transitions between probe transmission lines of different constructions within the system. In an exemplary probe system, there may be three or more transitions in each line before it is ultimately connected to the equipment testing the wafer. Each transition causes a reflection of signals and an increase in VSWR, thereby limiting the system bandwidth.

A further drawback of prior art probing systems is that the length of the transmission lines coupling the probing elements to the test equipment is difficult or impossible to optimize. Two counterveiling considerations influence the selection of an "optimum" transmission line length. The first is that the system bandwidth decreases as the line length increases, so it is important to keep the transmission lines as short as possible. The second consideration is that the coaxial connectors typically mounted on the ends of the transmission lines for connection to test equipment are relatively bulky. Accordingly, the transmission lines must extend sufficiently far from the probing elements so that there is adequate space for the requisite number of coaxial connectors to be mounted. The "optimum" transmission line length is the shortest length consistent with this second consideration.

In existing wafer probing systems, the length of the transmission lines coupling the probing elements to the interfacing connectors is determined principally by the size of the probe housing. This size determined length generally bears little or no relationship to the two line length selection considerations referenced above. Consequently, the transmission line lengths in existing probing systems are generally non-optimum and probe performance suffers accordingly.

While the performance of existing probe stations suffers from deficiencies due to non-optimum transmission line lengths, these deficiencies are magnified when testing wafers with either a relatively small or relatively large number of contacts. In the case of wafers having a relatively small number of contacts, existing probe housings are generally unnecessarily large and the transmission lines consequently unnecessarily long, thereby limiting system bandwidth. In the case of wafers having an extraordinarily large number of contacts, there is often insufficient space on the probe housing to mount the requisite number of connectors. Consequently, probes for wafers having an extraordinarily large number of contacts are not generally available.

Accordingly, a need remains for improved wafer probing systems.

SUMMARY OF THE INVENTION

It is an object of the present invention to reduce the number of transmission line transitions between a wafer being probed and associated test equipment.

It is another object of the present invention to provide a wafer probing system in which the length of the conductors coupling the probing elements to interfacing connectors is not dependent upon the size of the probe housing.

It is a further object of the present invention to couple all of the contacts on a wafer probe having several hundred contacts to coaxial connectors.

It is still another object of the present invention to provide a mechanically simple wafer probe.

It is yet another object of the present invention to gang-couple wafer probe elements to electronic test equipment interfacing conductors.

In accordance with the present invention, the interface between an integrated circuit probing element and associated test equipment is provided by flexible ribbon cables that include a plurality of transmission lines. The cables are not an integral part of the probe housing, so their lengths can be selected independently of housing size constraints and can be chosen instead to optimize probe performance. The ribbon cable construction eliminates the many transmission line transitions found in conventional probing systems, thereby increasing probe bandwidth. The ribbon cable can be formed for direct connection to associated test equipment to eliminate all transmission line transitions.

These and other objects, features and advantages of the present invention will be more readily apparent from the following detailed description, which proceeds with reference to the accompanying drawings.

BRIEF DESCRIPTION OF THE DRAWINGS

Fig. 1 is a top plan view of a semiconductor wafer probe system according to the present invention.

Fig. 2 is an enlarged fragmentary bottom view of a portion of the probe system of Fig. 1.

Fig. 3 is a sectional view taken along line 3-3 of Fig. 2.

Fig. 4 is a sectional view taken along line 4-4 of Fig. 2.

Fig. 5 is a sectional view of an alternative embodiment of the invention showing the interconnection between a polyimide film probe and an embedded microstrip ribbon conductor.

Fig. 6 shows a termination of a ribbon cable, partially in section, in which the center conductors of the cable are exposed for connection.

Fig. 7 is a sectional view depicting the interconnection of the cable termination of Fig. 6 and another cable which leads to test equipment.

Fig. 8 is a sectional view of the junction between a portion of a ribbon cable of the invention and an SMA coaxial connection.

Fig. 9 is a sectional view taken along line 9-9 of Fig. 8.

DETAILED DESCRIPTION OF PREFERRED EMBODIMENTS

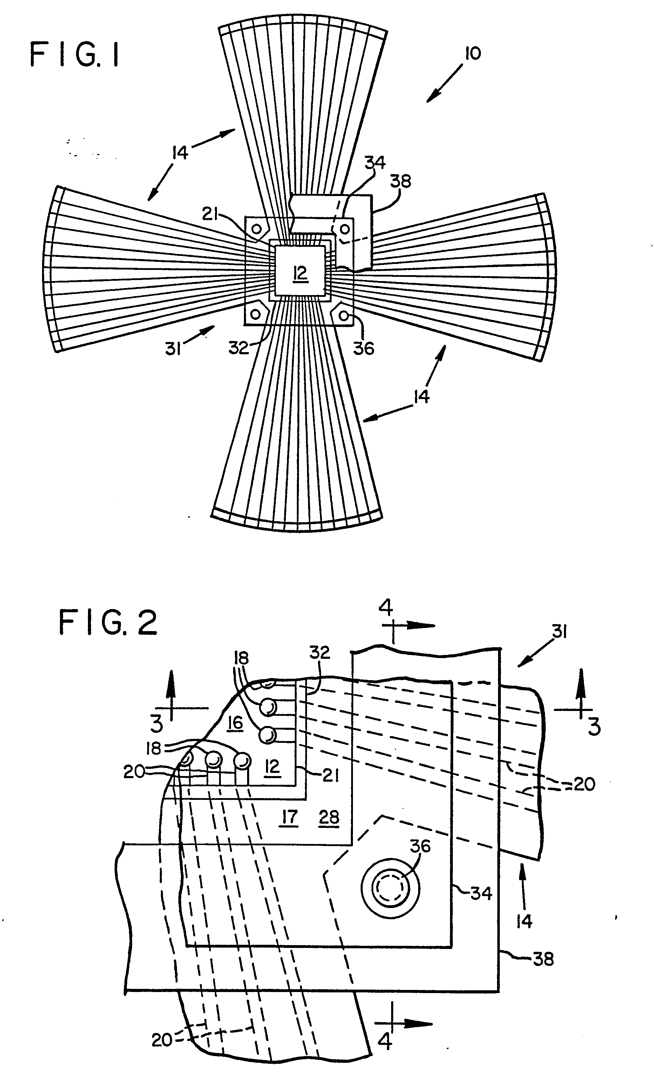

With reference to Fig. 1, a probe 10 in accordance with the present invention includes a probe head 12 and a plurality of ribbon cables 14. Each ribbon cable 14 includes a plurality of transmission lines which couple the wafer contacts on probe head 12 to external test equipment.

With reference to Figs. 2, 3 and 4, the illustrated probe head 12 includes a transparent sheet of polyimide film 16 on a first side of which is formed a plurality of electrically conductive wafer contact bumps 18. Wafer contact bumps 18 may be of nickel and are arranged in a pattern which matches the contact areas (bond pads) on the integrated circuit to be tested. A ground plane conductor 17 extends along the first side of probe head 12 up to an edge 21 adjacent wafer contact bumps 18. This ground plane minimizes stray coupling to and from the wafer.

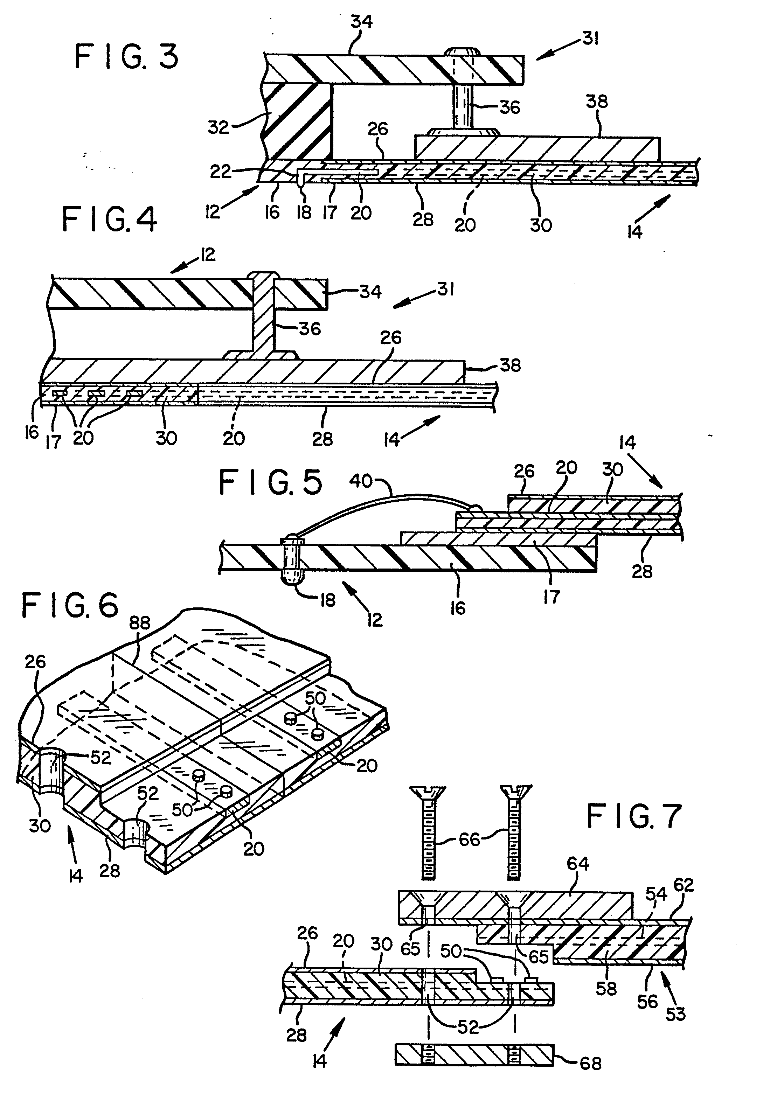

The interface between wafer contact bumps 18 and the external test equipment is made by ribbon cables 14. As best seen in Fig. 3, the illustrated ribbon cable 14 is of an embedded microstrip construction, with a plurality of coplanar transmission line conductors 20 interposed between upper and lower ground plane conductors 26, 28. The polyimide film 16, which forms the probe head 12, extends into the four ribbon cables. This film serves as an insulating material 30 separating transmission line conductors 20 from ground plane conductors 26, 28. Connections between transmission line conductors 20 and wafer contact bumps 18 are made by plated vias 22 through film 16.

At the connection to contacts 18, transmission line conductors 20 may be just a few tens of microns apart. As they extend radially away from probe head 12, however, conductors 20 diverge from each other within cable 14. By so doing, the spacing between adjacent transmission line conductors eventually becomes sufficient for a connector element, such as an SMA coaxial connector, to be connected to each of the transmission line conductors.

In the preferred embodiment, insulating material 30, conductors 20 and ground plane 24 are of a material and thickness that makes ribbon cable 14 flexible. Such flexibility facilitates positioning the cable for convenient connection to external equipment and can, as discussed below, allow the ribbon cable to be routed directly to the panel of the test equipment.

Although the probe illustrated in Fig. 1 uses four ribbon cable assemblies, a greater or lesser number of assemblies can be used. Similarly, although the outer conductors of each of the Fig. 1 ribbons diverge or flare apart from one another at an angle of approximately 35 degrees, other divergences can be employed to suit a particular application. Divergences approaching 180 degrees can be employed in the illustrated four cable system if the cables overlap each other.

The present invention can be adapted for use in a variety of wafer probing systems. Such systems generally include a structure for supporting a wafer, a structure for supporting a probe and a system for positioning the probe relative to the wafer.

A probe supporting structure 31 suitable for use with the present invention is shown in Figs. 1-4 and includes an elastic block 32, an inelastic backing plate 34, a support post 36 and a reinforcing rim 38. Elastic block 32, comprised of a material such as silicone rubber, is positioned on the surface of probe head 12 opposite contact bumps 18 and is held in slight compression by inelastic backing plate 34. Block 32 allows probe head 12 and probe contacts 18 to deflect when contacts 18 are pressed against the wafer so as to moderate the force transmitted to the wafer. Backing plate 34 is in turn held in place by support post 36 which is secured to reinforcing rim 38. Reinforcing rim 38 is secured to ground conductor 26 about the periphery of probe head 12 and prevents the expansive force exerted by block 32 from distorting the planar character of probe head 12.

Fig. 5 shows an alternative embodiment for interconnecting ribbon cable to a robe head. In this embodiment, probe head 12 is fabricated separately from ribbon cable 14 and is later bonded thereto. Again, ribbon cable 14 is illustrated as having embedded microstrip construction, with a plurality of coplanar transmission line conductors 20 interposed between upper and lower ground plane conductors 26, 28.

To connect ribbon cable 14 in Fig. 5 to probe head 12, ground conductor 26 and a portion of intervening insulating material 30 are removed from the end of the cable so as to expose a portion of transmission line conductors 20. Wire bonds 40 are then formed between exposed transmission line conductors 20 and wafer contact bumps 18 on polyimide film 16. Again, a ground plane conductor 17, in this case shown on the surface of probe head 12 opposite bumps 18, extends around the region defined by wafer contact bumps 18 so as to minimize stray coupling to and from the wafer.

Fig. 6 shows one technique for terminating the distal end of ribbon cable 14. Portions of the ground plane conductor 26 and the insulating material 30 between this ground plane and the transmission line conductors 20 are removed as shown to expose transmission line conductors 20. Contact bumps 50 are also formed on the exposed surfaces of the transmission line conductors to facilitate establishment of a pressure contact. Guide holes 52 are formed in cable 14 for use in aligning a mating cable so that the corresponding conductors of ribbon 14 and the mating cable are in registration with one another.

In the illustrated embodiment, conductors 20 are all of the same length so that the signal propagation delays from each of probing points 18 to the distal ends of conductors 20 are equal.

Fig. 7 shows one example of a ganged interface between the ribbon cable 14 of Fig. 6 and a ribbon cable which includes a set of instrumentation conductors 54 connected to test equipment. In the illustrated embodiment, instrumentation conductors 54 are also in embedded microstrip form and are shielded by upper and lower ground planes 62, 56. Connection is established by removing a portion of ground plane conductor 56 and the intervening insulation 58 so as to expose portions of the plurality of embedded instrumentation conductors 54. Ground conductor 62 in the instrumentation cable is also exposed by removing portions of conductors 54 and insulation 58. The exposed ground conductor 62 is reinforced by a stiff backing plate 64. Guide holes 65 through plate 64 and portions of ribbon conductor 53 are positioned to align with guide holes 52 of ribbon 14 when these ribbons are interconnected. The two ribbon cables 14, 53 are then pressure connected by means such as bolts 66 threaded through backing plate 64, holes 65 and 52 and into a clamping plate 68. These bolts are positioned intermediate the transmission line conductors 20. Bolts 66 serve the dual function of establishing pressure contacts between the corresponding elements of the mated transmission lines 20, 54 and insuring registration therebetween.

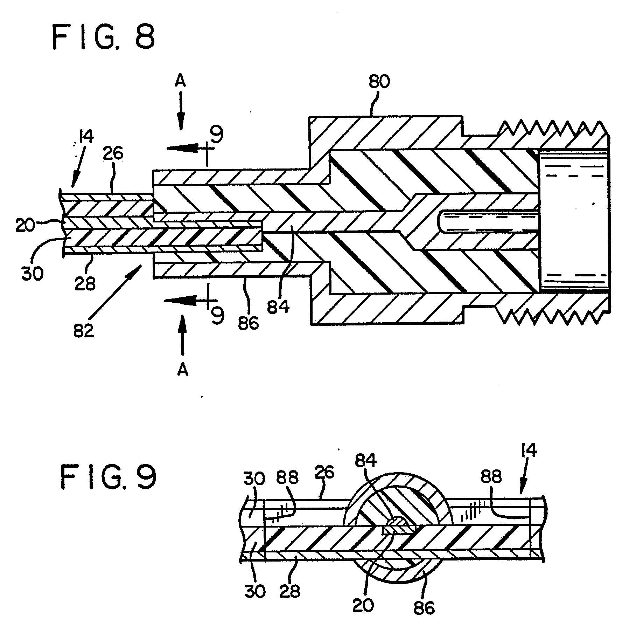

In other embodiments, the ribbon cable 14 of Fig. 6 can be terminated directly on a mating cable, such as that shown in Fig. 7, which is included on the front panel of the test equipment. Such an approach eliminates all transitions in the transmission line linking the wafer contact bumps to the test equipment. In still other embodiments, the transmission line conductors within ribbon cable 14 can be terminated individually at connectors such as SMA coaxial connectors. Such an interconnection is shown in Figs. 8 and 9.

To terminate transmission line conductors 20 at individual SMA connectors, ribbon cable 14 is again prepared as shown in Fig. 6 (but without contact bumps 50). A conventional SMA connector 80 is cut at 82 in a plane parallel to the axis of the connector. This cut intersects and exposes a planar surface of the center conductor 84 within SMA connector 80. The end of ribbon cable 14 is inserted into this cut and a crimping pressure is applied along lines A-A.

This establishes a pressure contact between center conductor 84 of SMA connector 80 and transmission line conductor 20 of ribbon cable 14. As shown in Fig. 9, this pressure also establishes contact between the grounded outer body 86 of SMA connector 80 and ground plane conductor 28 of cable 24. Ribbon cable 14 can be slit radially inwardly for a short distance from its terminal end along lines 88 (Figs. 6, 9) between transmission line conductors 20 so as to provide each of the SMA connectors attached thereto some freedom of movement.

While the illustrated embodiment shows the connection of ribbon 14 to a female SMA connector, the same principles could be applied for connection to male or female connectors of any type. Termination of transmission lines 20 in male connectors facilitates connection directly to the female connectors generally found on the front panels of electronic test equipment.

While the preceding has described several preferred embodiments, it will be appreciated that the present invention is not so restricted. Variations can be made in the illustrated structures without departing from the scope of the invention as defined by the appended claims and equivalents thereof. For example, although an embedded microstrip transmission line construction has been shown throughout, alternative geometries, such as coplanar line or multilayer embedded lines, could also be used. Similarly, although only a few interconnection schemes between the probe contacts and the ribbon cable have been shown, a multitude of other schemes, such as pressure contact interconnects, can be used. Finally, a variety of other probing structures, such as probing needles or styli, could readily be substituted for the thin film probe heads with which the invention has been illustrated. I claim as my invention all modifications coming within the scope and spirit of the following claims.

## Claims

1. In a wafer probing apparatus having a support member with a plurality of wafer probing points, the improvement comprising:

flexible cable means for coupling to the probing points, said flexible cable means having first and second ends and comprising a plurality of transmission line conductors and at least one ground conductor, said transmission line conductors being insulated from each other and from the ground conductor by an insulating material and diverging away from each other as they extend away from the first end, the transmission line conductors being connected at the first end to the probing points and at least a portion of the cable means being free to move relative to the support member.

2. The invention of claim 1 in which the cable means comprises a ribbon cable including first and second planar ground conductors on opposing surfaces of an insulating material and in which the transmission line conductors extend through the center of said insulating material in a plane parallel to said planar ground conductors.

3. The invention of claim 1 which further includes a plurality of connector elements and means for coupling said connector elements to the second ends of the transmission line conductors.

4. The invention of claim 3 in which:

the cable means comprises first and second planar ground conductors on opposing surfaces of an insulating material and in which the transmission line conductors extend through the center of said insulating material in a plane parallel to said planar ground conductors;

one of the planar ground conductors and the insulating material between said ground conductor and the transmission line conductors are absent from the cable means for a distance extending from the second end of the cable; and

the connector elements comprise SMA coaxial connectors which have been cut in a plane parallel to the connectors' longitudinal axes so as to receive the second end of the ribbon cable so that the center elements of the SMA connectors can establish contact with the transmission line conductors and the body of the SMA connectors can establish contact with one of the planar ground conductors.

5. The invention of claim 1 in which the plurality of probing points are arrayed in four rows defining a rectangle, the improvement further comprising four of said cable means, each of said cable means coupling the probing points in a single row to a plurality of connector elements.

6. The invention of claim 1 in which the distance from each of the probing points to their corresponding connector elements through the transmission line conductors are equal.

7. The invention of claim 1 which further includes a plurality of connector elements and in which the cable means extends away from the first end for a distance such that the transmission line conductors have diverged sufficiently away from one another to permit a connector element to be coupled directly to the second end of each of said conductors.

8. A method for interfacing from a plurality of wafer probing points to a plurality of electronic equipment conductors including a ground lead that couples to electronic equipment, comprising the steps:

providing a flexible ribbon cable having first and second ends, said cable including a plurality of coplanar transmission line conductors that diverge from each other as they extend from the first to the second ends, said line further including two planar ground conductors spaced above and below the transmission line conductors by an insulating material and in planes parallel thereto;

coupling the transmission line conductors at the first end of the ribbon cable to the wafer probing points;

removing a portion of one planar ground conductor at the second end of the ribbon transmission line and the insulating material between said removed planar ground conductor and the plurality of coplanar transmission line conductors so as to expose portions of said plurality of coplanar transmission line conductors;

establishing pressure contacts between the exposed portions of the plurality of coplanar transmission line conductors and the plurality of conductors that couple to the electronic equipment; and

establishing a pressure contact between a ribbon cable ground conductor and the ground lead that couples to the electronic equipment.

9. An apparatus for interfacing a plurality of wafer probing points to a plurality of electronic equipment conductors including a ground lead that couples to electronic equipment comprising:

a flexible ribbon cable having first and second ends, said cable including a plurality of coplanar transmission line conductors that diverge from each other as they extend from the first to the second ends, said line further including two planar ground conductors spaced above and below the transmission line conductors by an insulating material and in planes parallel thereto, one of said planar ground conductors and the insulating material between said ground conductor and the transmission lines not extending all the way to the second end so that the plurality of coplanar transmission line conductors is there exposed;

means for coupling the transmission line conductors at the first end of the ribbon cable to the wafer probing points; and

pressure connector means for establishing pressure contact between the plurality of exposed coplanar transmission line portions at the second end of the ribbon cable and the plurality of interfacing conductors that couple to the electronic equipment, said pressure connector means further including means for establishing pressure contact between one of the planar ground conductors and the ground lead that couples to the electronic equipment.

10. The apparatus of claim 9 in which the plurality of interfacing conductors that couple to the electronic equipment terminates in a coplanar array that matingly corresponds to the termination of the transmission line conductors at the second end of the ribbon line, the apparatus further including:

means for establishing registration between the corresponding electronic equipment conductors and transmission line conductors.

0259162

## FIG. 1

## FIG. 2

0259162

FIG. 3

FIG.4

FIG.5

FIG.6

FIG.7

0259162

# FIG. 8

# FIG. 9